# EUROPEAN PATENT APPLICATION

(11) **EP 1 283 589 A2**
(43) Date of publication of application: **12.02.2003**
(21) Application number: 02008380.4
(22) Date of filing: 12.04.2002
(51) Int. Cl.: H02M 7/00, H05K 7/14

(54) **Power converter module**

(30) Priority: 09.08.2001 DE 10139287; 21.01.2002 DE 10203246
(71) Applicant: Bombardier Transportation GmbH, 13627 Berlin (DE)
(72) Inventor: Krämer, Wilhelm, Dipl.-Ing., 69207 Sandhausen (DE); Flerlage, Heinz, Dipl.-Ing., 67133 Maxdorf (DE); Nordhäuser, Andreas, Dipl.-Ing., 64392 Seeheim (DE)
(74) Representative: Akers, Noel James

(57) **Abstract**

A power converter module for converting an input voltage to an output voltage, comprising a heat sink (6) and at least one power semiconductor module (2) mounted on the heat sink (6), a transformer (100) for galvanically isolating the output current from the input current is integrated within the module such that transformer and heat-sink may be cooled by the same cooling stream. Such a module with integrated transformer may be substantially lighter and more compact than conventional arrangements where the transformer is located separately. Power converters according to the invention may be employed in rail transport vehicles.

## Description

The invention relates to power converter modules in general, and more especially to power converter modules for electrical energy supply in the field of rail transport. Such modules are often used in the form of medium frequency (MF) auxiliary converters for supplying auxiliaries in locomotives, underground trains, trams and carriages. Typical auxiliaries include air conditioning units, lights, galley communication systems, compressors etc.

According to IEC/DIN Regulations power converters for use on board rail vehicles must be provided with galvanic isolation, whereby the auxiliary circuit is completely electrically isolated from the primary circuit coming from the supply rail or the locomotive circuit.

To this end, known MF transformers have been employed in multi-system power converters together with step-up converters whereby the transformer ensures the requisite galvanic isolation and the step-up converter allows various voltage regimes to be converted. Typical input voltages may be eg. AC: 1kV 16²/₃Hz, 1.5kV 50Hz or DC: 1.5kV, 3kV. While in the following, reference is made to a step-up converter, the teachings of the present invention may apply equally to step-down converters.

A prior art power converter module is known from DE19813365 A, which discloses a compact module incorporating power semiconductor elements mounted upon a heat-sink. The module includes a low-inductance busbar connection arrangement between the power semiconductors.

Conventional MF-transformers are typically large and heavy. Known rectangular and cylindrical transformer constructions have a rather high weight/power ratio of about 0.4 - 0.6 g/W at 6 - 12 kHz with a transfer power of between 30 kW and 100 kW. As a consequence of their size and weight, these known MF-transformers are usually designed to be installed in a rail vehicle in series with (usually on the output side) but separately from the MF- converter module. In particular, the weight limitation for exchargeable converter modules imposed by Deutsche Bahn and other rail companies is about 60 kg, which excludes the integration of the transformer within the module.

A further impediment to inclusion of the transformer within the module is the need for adequate cooling. Converter modules for use in the rail transport industry are usually arranged in the electrical installation cabinet in such a way that the heat-sink is cooled by a first cooling flow e.g atmospheric air circulation, while the remaining components (power and control electronics) are cooled by clean air from a separate, closed-circuit cooling air supply.

One DC/AC converter available from AEG SVS Power Supply Systems includes a transformer within the module, but this arrangement requires special cooling since the transformer cannot be cooled by the atmospheric circulation, as it is arranged on the clean side of the module. Typically, transformers must be cooled by atmospheric air and/or by additional water coolers to ensure sufficient heat dissipation, which require additional space to be provided in the electrical installation cabinet.

In addition, conventional MF-transformers are not suitable for direct installation in the MF-power converter module in close proximity to the IGBTs (Insulated Gate Bipolar Transistor) which are generally used for the step-up converter.

In order for such compact transformers to be built into the power converter module itself, it is desirable to place the primary and secondary windings in the cooling air stream of the module heat-sink. The construction of present transformers does not permit this. To achieve efficient operation the windings must be placed closely around the earthed core with spacers in between. As a result, there is always a danger of partial discharge in the gap between windings, spacers and the core which can in the long term lead to breakdown of the winding insulation.

The current practice of arranging the MF-transformer outside the power converter module has a number of significant disadvantages: it takes up additional space within the electrical installation cabinet; it adds to overall weight; and in particular, the separated arrangement of the MF-transformer and the power converter module fundamentally affects the functioning of the resonant part of the power converter circuit, since the inter-connecting cabling alters the capacity and inductance of this resonant circuit.

According to the present invention there is provided a power converter module for converting an input voltage to an output voltage, comprising a heat sink, a power semiconductor module mounted on the heat sink and a transformer for galvanically isolating the output current from the input current, the transformer being integrated within the module such that the transformer and heat-sink may be cooled by the same cooling stream.

The power converter module of the present invention offers the advantage that additional space for the transformer outside the power converter module is not needed and a low induction busbar system can be used for the resonant circuit.

A prefered MF-transformer for use in the power converter module of the present invention is disclosed in unpublished patent application DE 102 03 246.7. This transformer comprises primary and secondary windings, which are encased in an insulated coil moulding. An air gap between the coil moulding and transformer core thermally and electrically isolates the two. Since mechanical/metallic fixtures such as spacers, bolts etc. are no longer required to support the windings or the core, the potential in the core can be allowed to float between the voltages of the primary and secondary coils without the danger of partial discharge or arcing. The dielectric flux displacement causes only a very weak charge in the core, and poses no danger even in the absence of shielding. The relatively large air gap between the coil moulding and the core permits efficient cooling of the core and of the coils of the MF-transformer directly in the air stream, of the power converter cooler. The coils and connections for the transformer can thereby be located in the power converter cooling module air stream whereby a particularly compact construction results without danger of arcing. In a particularly convenient embodiment, the coil moulding can itself function as the actual supporting member for the transformer. In order to facilitate the assembly of the MF-transformer, the magnetic core may also be composed of partial core sections which are assembled together within the primary and secondary windings.

With a transformer of this construction, very advantageous weight/power ratios are obtainable. For example weight/power ratios of 0.2 to 0.25 g/W may be achieved at 6-12 kHz and transmission of 30 to 100 kW. Further, significant weight savings can be obtained with this arrangement. For example, allowing weight savings of up to 50% over conventional devices are easily acheived. Significantly, by integrating such transformers within the power converter module, the savings are even greater as total power is increased, since a doubling of the transformer rating requires only slight additional weight increases for the remaining components of the module. It is envisaged that modules of this construction may be used for low power propulsion systems (LPP) or even in the range of medium power propulsion (MPP). It is furthermore envisaged that even locomotives in the high power propulsion (HPP) range may be able to benefit from the technology.

Other sufficiently insulated and compact transformers can be employed in an integrated power converter module of the present invention. It is also within the scope of the invention that two or more smaller transformers could be mounted on an appropriately constructed heat-sink e.g. in order to increase the power of the module.

Embodiments of the present invention will now be described by way of example only having reference to the accompanying figures, in which:-
- Figure 1: is a perspective view of the base layer of a power converter module according to the present invention;
- Figure 2: is a cross-sectional view of an IGBT semiconductor with insulating frame mounted on a heat-sink;
- Figure 3: is a view of the power converter module showing the cooling elements;
- Figure 4: is a perspective view of an MF-transformer for integration into a power converter module;
- Figure 5: is a cross-sectional detail of one embodiment of the transformer mounting;
- Figure 6: is an alternative embodiment of the transformer of Figure 4 in partial section;
- Figure 7: is a perspective view of the power converter module of Figure 1 with busbars and capacitors;
- Figure 7a: is the power converter module of Figure 7 in viewed along arrow VIIa;
- Figure 8: is a perspective view of the power converter module of Figure 1 with a side plate in position,
- Figure 9: is a perspective view of a power converter module according to the present invention with cover plate;
- Figure 10: is a partial cross-sectional view of one embodiment of the input and output terminals of the power converter module;
- Figure 11: is a view of a further embodiment of the power converter module of the present invention with lengthwise air flow; and
- Figure 12: is a circuit diagram for a power converter module operating as an AC/DC MF-converter.

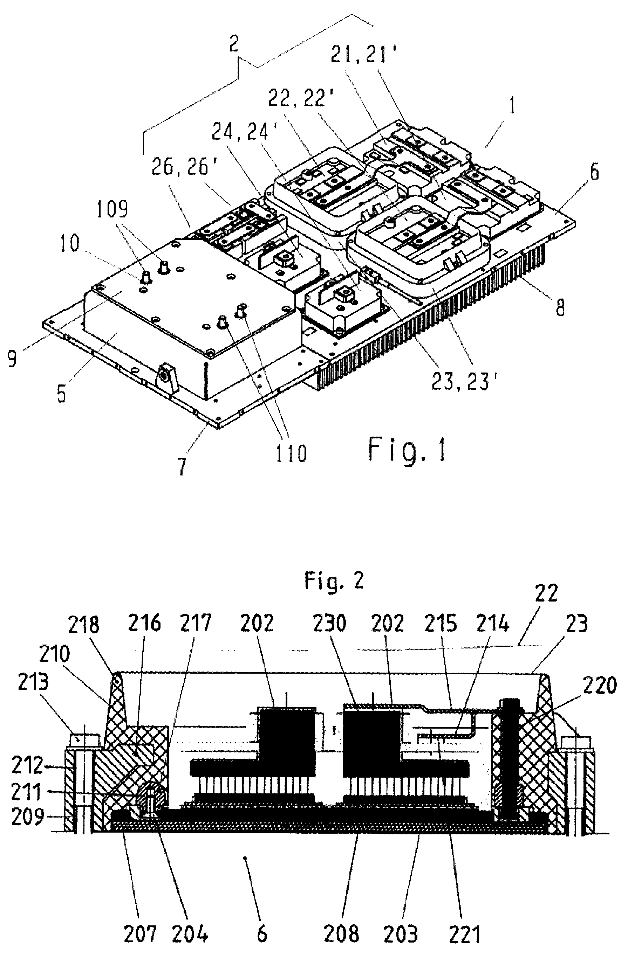

Figure 1 shows a power converter module (1) according to the present invention in perspective view. The power converter module (1) comprises a heat-sink (6), which serves as a base element and a first layer of the module. The heat-sink (6) is formed of sintered aluminium. Alternatively, the heat sink may be formed from any other sufficiently thermally conducting materials, such as other forms of aluminium or other metals. On a first surface, the heat-sink (6) is provided with cooling elements in the form of transverse ribs (8). Alternative forms of cooling elements may be employed as appropriate, for example ribs extending longitudinally, provided that the required heat dissipation duty is met. When installed in the electrical installation cabinet, the ribs (8) are arranged in the air stream in order to ensure adequate dissipation of the heat produced in the power converter module (1).

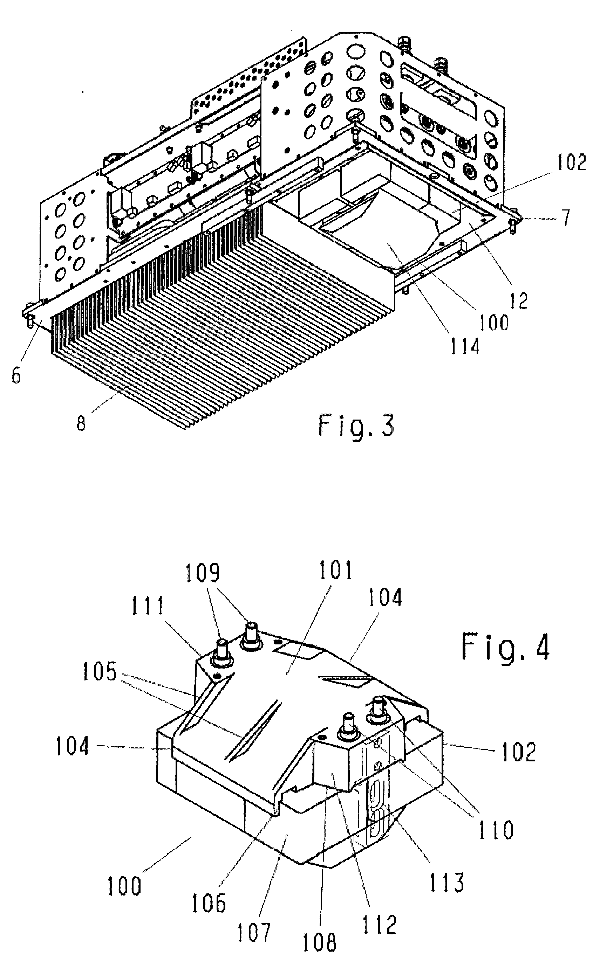

According to the present invention, the heat-sink (6) is provided with a heat-sink extension plate (7) for receiving a transformer (100) (as shown in Figure 3). The heat-sink extension plate (7) may be a separate element as is shown in Figure 1, connected to the heat-sink (6) by brackets or other means, or it may be integrally formed as part of the heat-sink (6) itself. In the figures the heat-sink extension plate (7) is shown in the same plane as the heat-sink (6). Other arrangements are also possible, whereby the heat-sink (6) and the heat-sink extension (7) may be located at an angle to one another. Alternatively, the transformer may be located on a separate plate located within a single integrated power converter module. Cooling elements such as ribs (8) may also be located in this area of the heat-sink (6).

The heat-sink extension 7 is provided with a cowling (5), which serves to house the transformer (100). The cowling (5) may also be formed integrally with the heat-sink (6) or with the heat-sink extension (7). Alternatively, the cowling may be connected to the heat-sink extension (7) by welding or other mechanical fixation methods. The cowling (5) separates the area beneath the heat-sink (6), which is subject to atmospheric cooling, from the zone above the heat-sink (6) which is cooled by a separate cooling system providing clean air. The cowling (5) should preferably be sealed to the heat-sink extension (7) to provide hermetic separation between the two zones, preventing any passage of contaminants.

For insulating purposes, the whole upper surface of the cowling (5) is formed by an insulating pate (9) as shown is Figure 1. Alternatively, the whole cowling may be made from insulating material. Openings (10) are provided through the insulating plate (9) for the input and output connections (109), (110) of the transformer (100).

Alternatively, the cowling could be omitted and the transformer (100) could be located below the heat sink (6) or heat sink extension (7), with suitable openings provided for the input and output connections (109), (110) of the transformer (100).

The heat-sink (6) is provided on its second surface with power semiconductor modules (2). These modules, described in further detail below, are electrically isolated from the heat-sink (6), but are in good thermal contact therewith. Figure 1 shows input diodes (21), (21') (required for AC input), step-up converter IGBTs (22), (22') arranged on insulating frames (23), (23'), resonant IGBTs (24), (24') and output diodes (26), (26'). Although in the present embodiment IGBTs are referred to as forming the basic switching elements of the power converter module, it will be appreciated that other forms of switching element may be employed to achieve the same or similar result.

In the embodiment shown in Figure 1, only the step-up converter IGBTs (22), (22') are mounted on insulating plates. Alternatively, for certain high voltage operating conditions, other components such as the resonant IGBTs (24), (24') may be arranged on such insulating frames. This could be necessary e.g. in the use of two modules arranged in series under 3kV DC input.

For ease of location of the power semiconductor modules (2), the heat-sink (6) is provided with a pattern of locating holes (not shown), which permit IGBTs with or without insulating frames and other components to be mounted directly on to the heat-sink surface.

Figure 2 shows in partial cross-section a step-up converter IGBT (22) mounted on an insulated frame (23) according to unpublished patent application DE 101 39 287.7. The actual IGBT (230) has on its upper surface electrical connections (202) and is provided on its lower surface with an electrically conducting base plate (203). Bores (204) in the edge region of the base plate (203) are provided for mounting and centring the IGBT (230) in the insulation frame by the use of threaded inserts (211) embedded within the insulating material or other similar connection elements.

This allows the semiconductor device (22) to be affixed to the heat-sink (6) not by normal direct screw connection but indirectly through bores (204), threaded inserts (211) and bolts (213) of the insulation frame (23). The insulation frame (23) presses the IGBT (230) via an intermediate ceramic plate (208) against the heat-sink (6). The function of the ceramic plate (208) is to electrically insulate the IGBT (230) from the heat-sink (6), while ensuring good thermal contact to ensure dissipation of heat from the IGBT to the heat-sink (6). To this end, the ceramic plate (208), is be formed from aluminium nitride or aluminium oxide or other materials having similar properties. The ceramic plate (208), is of slightly greater surface area than the base plate (203) such that a peripheral free edge region of constant width extends around the base plate (203), which serves to receive an elastic electrical gasket (207) between the insulating frame (23), ceramic plate (208) and base plate (203). The electrical gasket (207) may be made from nonconducting soft rubber or plastic. By providing a coating of silicon paste or other substitute an oxygen seal for the rubber or plastic material is achieved which may ensure an adequate life span in even the harshest environments. The electrical gasket (207) functions together with the ceramic plate (208) and the insulating frame (23) as an electrical barrier and prevents any movement of charge carriers. Under conditions of particularly high voltage two gaskets may be used, one within the other and effectively arranged in electrical series.

Preferably, the ceramic plate (208) is sufficiently thick such that the resulting electrical field strength remains small whereby, together with other measures known in the art, a high degree of safety with respect to partial discharge is achieved. Should a crack develop through the ceramic plate (208), a short circuit or spark-over should not occur, as the necessary charge carriers would not be produced by the weak field.

According to one preferred embodiment, the insulating frame (23) may comprise two main components, an outer frame (209) and an insulating body (210) within, but partially enveloping this outer frame (209). The outer frame (209) is preferably formed of metal (eg. aluminium casting) and the insulating body (210) is preferably formed of an electrically insulating plastic, in particular of a carbon fibre reinforced plastic such as epoxy resin, polyester resin or PPS material without conducting properties. By the inclusion of an outer frame (209) supporting the insulating body (210) it is ensured that the insulating material is not subjected to tension or sheer forces and is primarily placed under compression. The material which is used for the insulating frame (23) including the insulating body (210) is preferably resistant to partial discharge. A high strength, flaw-free connection with the insulating material can be achieved by the use of vacuum moulding or pressure injection techniques, in combination with an outer frame (209) having a fine profile.flaw-free

It is further preferred to provide in the insulation frame (23) or insulating body (210) embedded components in the form of threaded inserts (211). These integrated threaded inserts (211) are provided at the exact locations of the bores (204) of the base plate (203) whereby the threaded inserts (211) serve as centring elements for locating the insulating frame (23) in the fixation means (204) on the base plate (203). This permits easy centring of the IGBT (230) in the insulating frame during assembly.

The threaded inserts (211) in their assembled state exert a pre-determined pressure on the base plate (203) of the semiconductor module (22), and ensure the necessary pressure for optimum heat transfer. Irregularities in the upper surface of the heat-sink (6) are compensated for by the threaded inserts (211) such that the semiconductor module is pressed equally over its whole surface area. The joint between the upper surface of the heat-sink (6) and the ceramic plate (208) may be filled with a durable non-flowable, insulating, heat conductive paste (eg. silicon heat conductive paste). This allows homogeneous heat dissipation from the heat-sink (6) and also ensures that no dirt particles may enter, which could lead to partial discharges during use.

As mentioned above, in order to mount the insulating frame on the heat-sink (6) there are preferably provided in the immediate proximity of the threaded inserts (211), bores (212) through the insulation frame (23), through which bolts (213) may be inserted into corresponding tapped holes in the heat-sink (6). The heads of the bolts (213) are arranged behind an insulating ridge (218) formed around the insulation frame (23). In this way a sufficient discharge gap is achieved between the heat-sink (6) and the busbars or connections of the IGBT (230). Alternatively, the heat-sink (6) may be provided with corresponding bolts, which insert through the bores or openings (212). The heads of the securing bolts (213) may also be sunk in the frame (209) in order to increase the discharge gap.

The frame (209) is provided with a certain lever arm (216), as shown in Figure 2. The force exerted by the bolts (213) is transmitted via the cantilever arm (216) of the frame, through the insulating body (210) and the pressure frame (211) to the base plate (203). A small gap between the insulating frame and the heat-sink (6), ensures that the force exerted by the bolts (213) is effective.

In order to permit operation under conditions of high voltage and/or power, electrical connections (214, 215) are provided between the gate (221) of the IGBT (230) and the base plate (203) and/or between the emitter (202) and the base plate (203). These electrical connections (214, 215) to the base plate (203) are preferably provided by a pressure transfer member (220) in the insulation frame (23) or insulating body (210), which ensures electrical connection from the threaded insert (211) to the electrical connections (214, 215) through the use of screws which can be accessed from the upper surface of the IGBT (230). The pressure transfer members (220) thus have a double function. First, they ensure a spark free electrical connection as described above. Second they provide mechanical pressure in the centre of the semiconductor module.

By tailoring the resistance and capacitance of the electrical connections (214,215) and the pressure transfer member (220), the potential difference between the transistor or semiconductor chip or its ceramic isolation eg. the ceramic plate (208) and the metallic and electrically conducting base plate (203) can be reduced to just a few volts. Furthermore, no undefined intermediate voltages can be produced. In state of the art devices without insulating frame (23), the potential difference can reach critical values, particularly in the edge region, leading to partial discharge and arcing. With the insulation frame (23), the critical areas for electrical field strength are shifted to the strongly insulating ceramic plate (208), the insulating body (210) and its surrounding insulating rim (218) and the electrical gasket (207). As a result of the above mentioned provisions these areas are more suited to coping with such high values of electrical field strengths in simple and efficient ways. The insulating rim (218) is designed to achieve the necessary spark gap and leakage path, between the IGBT (230) and its connections and the bolts (213).

The use of the insulation frames (23) allows IGBT modules, especially those conceived for low voltage application, to be used under high voltage conditions. Thus a standard 650V module may be used for 1300V, 2600V or even 3900V. This universal application for low and high voltages is achieved by the functional co-operation of the insulation frame (23) and the electrical connection of the pressure transfer members (220) between the base plate and the emitter and gate connections. In particular, in the edge regions of the base plate (203), critical voltage levels and electrical field strength between the IGBT (230) and the metallic and electrically conducting base plate (203) are reduced to just a few volts. The insulating rim (218) of the insulation frame (23) should extend to at least the height of the IGBT (230). The resulting field strengths are significantly reduced.

Although in the figures, step-up IGBTs (22) with insulation frames (23) are shown, they may be used under low voltage conditions without the insulation frame (23). It would also be possible under high voltage conditions to use high voltage IGBTs without insulation frames. These have however at present the disadvantage that their low switch frequency significantly limits the working frequency of the step-up converter and the resonant circuit.

It is also possible to provide insulation frames for some or all of the other components, particularly under conditions of high-voltage input and output. In such cases, it may be convenient to mount two or more components e.g. the output diodes, on a single, appropriately shaped insulation frame.

Figure 3 shows a view of the underside of the power converter module (1) including the transformer (100). The heat-sink (6) is provided in the region of the heat-sink extension (7) with an aperture (12). The transformer (100) is arranged in the aperture such that the core (102) and the windings (114) are exposed to the cooling air flow. The transformer or a part thereof may protrude below the level of the heat-sink extension. It is preferred that the transformer (100) should not protrude below the level of the ribs (8). It is also possible to provide deflectors or swirl vanes (not shown) to direct the air flow through the aperture into the cowling.

Figure 3 shows a single transformer (100). It would however be possible to include two or more transformers (100) on a single heat-sink (6) eg. each mounted in an appropriately shaped aperture. This could allow different circuits and voltage regimes to be achieved. In order to integrate the transformer (100) into the power converter module (1), the transformer, may be provided with sufficient galvanic isolation according to IEC/DIN regulations to ensure that partial discharge between the primary and second windings and/or between the heat-sink (6) and power semiconductors (2) is prevented. As such, a preferred transformer as disclosed in unpublished patent application DE 102 03 246.7 may be used as shown in Figure 4. The transformer (100) comprises a coil moulding (101) of a generally rectangular shape having rounded corners. The transformer comprises a primary winding and a secondary winding which may be split equally into upper and lower layers. The coil moulding is formed as a hermetically sealed block. The coil moulding (101) can also serve as a mounting for the core (102) of the transformer (100).

The core (102) can be formed as two pairs of identical half cores which are inserted into the coil moulding and joined at their faces. Angle pieces (104) are provided on either side of the coil moulding and serve to support the half cores. The angle sections together with the coil moulding (101) serve to effectively surround and hold the outer legs of the cores (102). The angle sections (104) are integrally formed as part of the core moulding. Ribs (105) may be provided to reinforce these angle sections (104).

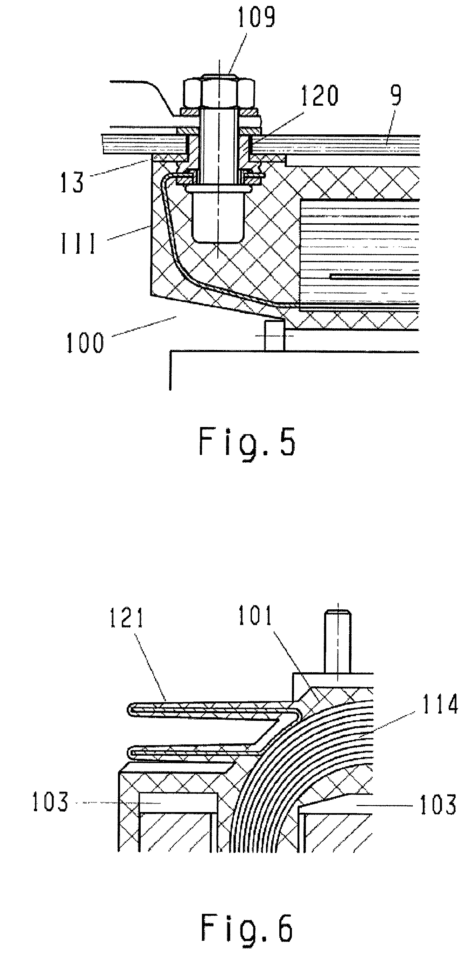

The outer surfaces (106) of the core (102) may be glued to the inner surface (107) of the angle sections (104), whereby an air gap (103) (see Figure 6) remains between the core (102) and the coil moulding (101). In this way, the core (102) can hang freely within the coil moulding only connected at the surfaces (106), (107).

The end faces of the coil moulding (101) may be provided with spacing members (not shown) which may be integrally formed with the coil moulding (101). These spacing members may engage the upper and lower surfaces of the core (102) during assembly and gluing.

The electrical connections (109), (110) for the primary and secondary windings are arranged on connecting blocks (111), (112) on the end faces of the coil moulding (101). Additional clips (113) may be provided on these connecting blocks (111), (112) to laterally restrain the core (102). Nevertheless, even without such clips the glued core (102) is held extremely securely and quietly in the coil moulding (101).

All of the components for the fixation of the core (102) are formed of nonconducting materials, so that the potential of the core (102) may float freely. In contrast to prior art transformers, the core (102) is not earthed. Advantageously, a ferrite nanocrystalline or amorphous core may be used.

As can be seen from Figure 5 the connecting blocks (111), (112) also provide for the mechanical connection of the transformer (100) within the cowling (5). The transformer is arranged to hang beneath the insulating plate (9) and is thus completely insulated from the heat-sink (6) or the heat-sink extension. The connecting blocks (111), (112) are provided with seals (13) and for further support, moulded bushings (120) may be provided whereby complete protection against passage of dirt particles, damp and other contamination is achieved. As mentioned above, an arrangement without cowling (5) is also contemplated whereby the connecting blocks (111, 112) provide for mechanical connection below a suitably insulated part of the heat sink (6).

As a result of its reduced size and weight the transformer (100) can be arranged in the cooling air flow such that the air flows over all surfaces and through the air gap (103). Figure 6 shows how further cooling fins (121) may be provided for the windings (114). In order to maintain galvanic isolation of the transformer windings, the cooling fins (121) are preferably completely embedded in the moulding material of the coil moulding (101). Other methods to ensure the insulation of the cooling fins (121) eg. a powder coating may also be used.

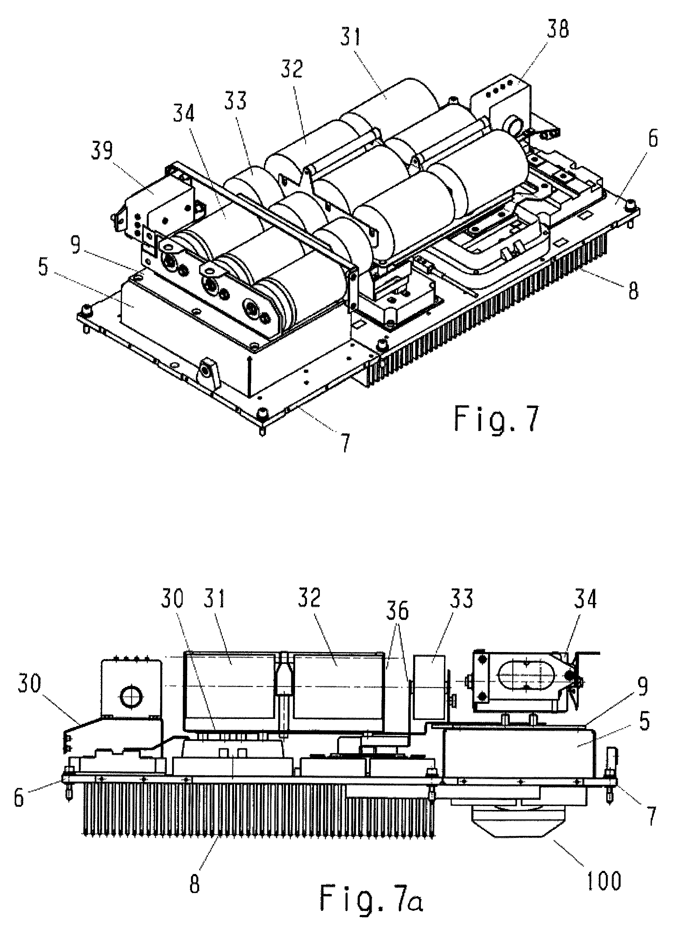

Figure 7 and Figure 7a show the further construction of the power converter module (1) according to the layer construction method known from earlier patent publication no. DE 19813365A. A low induction busbar arrangement (30) is provided above the power semiconductor modules (2) and ensures the electrical connection of the input diodes (21), (21'), step-up converters (22), (22') and resonant circuit (24), (100). Uprights (36) provide mechanical support and electrical connection to the capacitor groups (31), (32), (33), (34) and the discharge resistances (not shown).

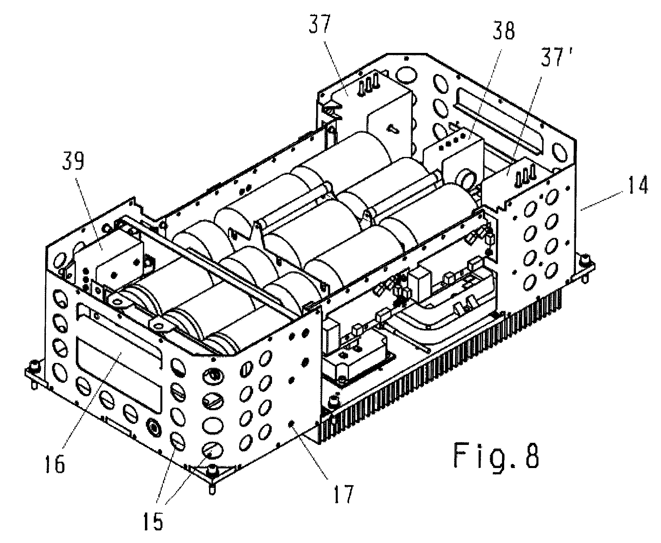

Figure 8 shows the power converter module (1) provided with a sidewall (14) in the form of a metallic plate. To also ensure sufficient air circulation on the upper surface of the heat-sink (6) the sidewall (14) is provided with ventilation means in the form of openings (15) which allow passage of the clean cooling air. The sidewall (14) can also be mounted on the heat-sink (6) in such a way that it serves as a further heat dissipating element.

For ease of handling, the sidewall (14) may be provided with handles (16). For mounting the module within the electrical installation cabinet the sidewall (14) may also be provided with fixation holes (17), so that the complete module may be mounted eg. on telescopic rails.

Figure 8 also shows input voltage sensors (37), (37'), input current sensor (38) and output voltage sensor (39) mounted on the inner surface of the sidewall (14).

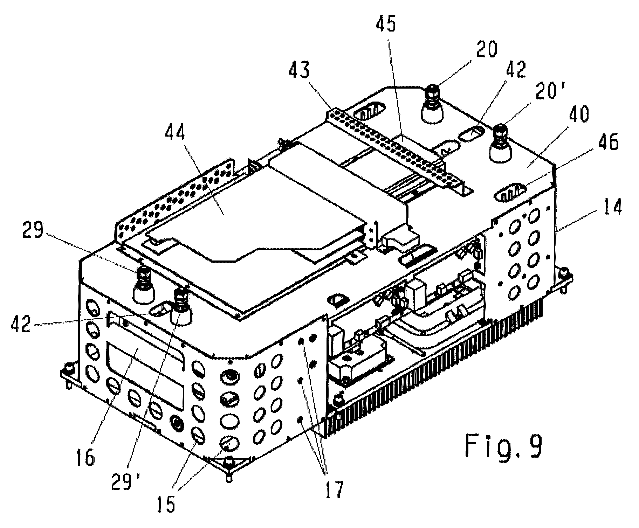

Figure 9 shows the power converter module (1) with a cover plate (40) formed of metal or plastics. For handling the module the cover plate may also be provided with carrying elements such as carrying points (42) for use with lifting equipment, such as hoists, during installation in the electrical installation cabinet and also grip (43).

For the control of the power converter module (1) control electronics module (44) and voltage control electronics (45) are provided on the cover plate for ease of access. To permit connection to the sensors (37), (38), (39) the cover plate is provided with openings (46) which coincide with the connections to those sensors.

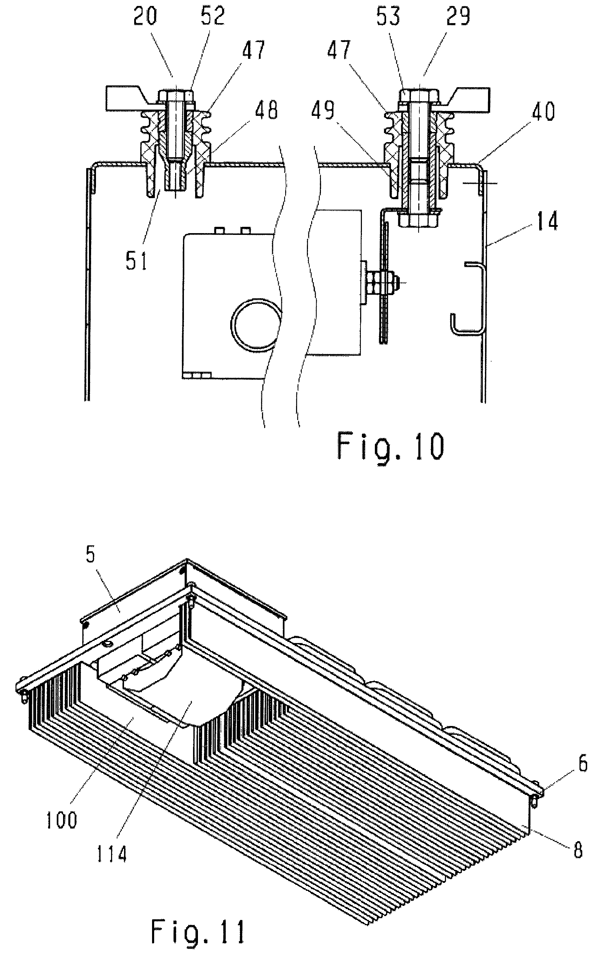

Advantageously and significantly, the power converter module comprises only two connections each for input and output to eg. the collector rail or locomotive circuit on the input side and to the auxiliary circuit on the output side. The connections through the cover plate for input (20), (20') and output (29), (29') are shown in Figure 9 and Figure 10. For practical and constructional purposes, input and output connections are similar but differentiated. On the input side, a reduction in the cross-section of the contact is provided in order to form an annular gap (51) between the insulated collar (48) and the connecting bushing (47). This has the effect of extending the leakage path. It is also advantageous to provide the inputs and outputs with different thread sizes to receive e.g different gauge bolts (52) and (53) to ensure that misconnection cannot take place.

Figure 11 shows a perspective view of a second embodiment of the power converter module (1), in which the ribs (8) are arranged in the longitudinal direction of the module for lengthwise airflow. The transformer is arranged at 90° to the position of Figure 1 whereby the air gap (103) between the coil moulding (101) and the core (102) aligns with the direction of the ribs (8). In this embodiment, the heat-sink (6) is formed together with its extension as a single element in which the transformer (100) is mounted.

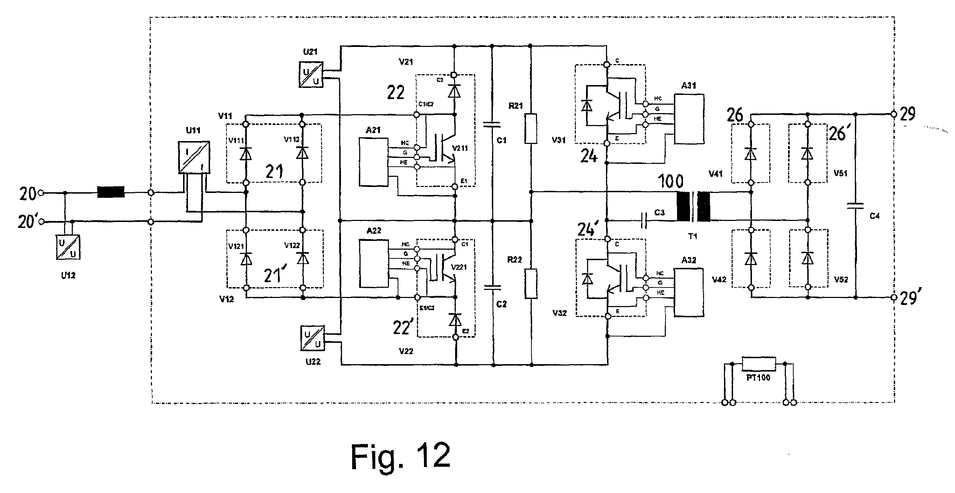

A circuit diagram for a power converter module according to the present invention as shown in Figure 1 is shown in Figure 12. The circuit is adapted to convert an input alternating voltage (AC) into an output direct voltage (DC). Typically, input voltages may be 1kV at 16²/₃ Hz and 1.5 kV at 50 Hz AC or 1.5 kV DC or 3kV DC. At the input side, input diodes (21), (21') are provided to rectify incoming AC current from the collector rail or locomotive circuit to the double step-up converter (22), (22'). The IGBTs forming the double step-up converter are driven by pulse width modulation of the gate drive units (GDU) to give a regulated intermediate voltage at the input to the resonant circuit. In the case of high input voltages eg. 3kV DC, 1.5 kV AC, the insulating frames (23), (23') described above may be used. Under these conditions, this double step-up converter may be driven at frequencies of up to about 3kHz.

The resonant circuit comprising transformer (100), IGBTs (24), (24'), output diodes (26), (26'), resonant capacitor (33), output capacitor (34) and discharge resisters is driven to oscillate under the control of GDUs (52), (52') at a resonant frequency of between 8 kHz and up to 20 kHz, whereby a low loss conversion of the resonant circuit input current to converter module output current is achieved. The combination of output diodes (26), (26') and the output capacitance (34) ensures a smooth, perturbation-free, direct current output (29) of eg. 650V DC to the auxiliary circuit.

It is within the scope of the present invention that the main components are arranged in other configurations to achieve alternative results. For example, the input diodes (21, 21') may be omitted to function with only direct current input. Furthermore, two or more circuits each with its own transformer may be combined. In this case, all circuits may be arranged on the same heat-sink. Alternatively, each heat-sink may have its own separate circuit.

Although the figures described above show the transformer to be connected at the output side of the power converter it is also possible to provide the transformer on the input side.

In embodiments using a plurality of modules, the outputs can be connected in parallel with the inputs arranged in series in order to achieve greater voltage conversion. The skilled man will be aware of many other alternative connection arrangements whereby one or more such modules may be adapted to provide eg. single or multi-phase AC output from an AC or DC input.

While the above description has focussed on the use of such modules for rail transport applications, it is to be noted that such compact integrated power converters may be adapted for use in any circumstances where a galvanically isolated power converter is required. Such circumstances may include back-up or auxiliary power supplies for computer installations or other delicate equipment.

## Claims

1. A power converter module for converting an input voltage to an output voltage, comprising a heat sink, a power semiconductor module mounted on the heat sink and a transformer for galvanically isolating the output current from the input current, the transformer being integrated within the module such that the transformer and heat-sink may be cooled by the same cooling stream.

2. A power converter module according to Claim 1, wherein the heat-sink is a plate having an aperture, the transformer being located within the aperture such that in use the windings and transformer core are within the heat-sink air stream.

3. A power converter module according to Claim 2, wherein a cowling is arranged over the aperture, the cowling being of a size to cover the transformer, and whereby the transformer is arranged to be substantially free of contact with the cowling or the heat sink.

4. A power converter module according to any preceding claim, wherein the transformer is provided with connections for the primary and secondary windings and whereby the transformer is supported by these connections.

5. A power converter module according to Claim 3 and Claim 4, wherein the cowling comprises an insulating plate and wherein openings are provided in the insulating plate, through which the transformer connections may be passed and secured.

6. A power converter module according to any preceding claim, **characterised in that** the transformer windings are encased in an insulating coil moulding.

7. A power converter module according to Claim 6, wherein an air gap is provided between the coil moulding and the transformer.

8. A power converter module according to any preceding claim wherein the heat-sink is provided with cooling elements in thermal connection with the semiconductor module.

9. A power converter module according to any preceding claim, wherein the semiconductor module is arranged on a heat transmitting, electrically insulating frame, directly mounted to the heat-sink, whereby the semiconductor module is electrically insulated from the heat-sink but nevertheless in good thermal contact therewith.

10. A power converter module according to any preceding claim, wherein the power converter module comprises a medium frequency power converter module with step-up converter and resonant circuit.

11. A power converter module according to Claim 10, wherein the resonant circuit is internally connected within the module, whereby only two power connections for input to the module and output from the module are provided.

12. A power converter module according to Claim 11, wherein the internal connection is provided by a low inductance busbar system.

13. A power converter module according to Claim 12, wherein the busbar system includes uprights which provide mechanical support for the capacitors of the resonant circuit as well as ensuring their electrical connection.

14. A power converter module according to any of Claims 10 to 13, wherein all connections to the module including input, output and control are arranged on a cover plate.

15. A power converter module according to any of Claims 11 to 14, wherein input and output connections are provided with different threads whereby incorrect connection is avoided.

16. A power converter module according to any preceding claim wherein a sidewall is provided on the heat-sink, to surround the transformer and the semiconductor modules, the sidewall being provided with ventilation means.

17. A power converter module according to Claim 16, wherein the sidewall is further provided with carrying handles and/or connecting elements.

18. A power converter module according to any preceding claim wherein two or more transformers are integrated on the heat-sink.

19. A power converter module according to any preceding claim wherein the converter is adapted to convert AC or DC input to DC output.
